(19) Europäisches Patentamt
European Patent Office
Office européen des brevets

(11) EP 1 490 962 B1

(12) EUROPÄISCHE PATENTSCHRIFT

(45) Veröffentlichungstag und Bekanntmachung des Hinweises auf die Patenterteilung:
**07.05.2008 Patentblatt 2008/19**

(21) Anmeldenummer: **03717137.8**

(22) Anmeldetag: **06.03.2003**

(51) Int Cl.:
***H03D 3/00*** *(2006.01)* ***H03D 3/04*** *(2006.01)*

(86) Internationale Anmeldenummer:
**PCT/DE2003/000731**

(87) Internationale Veröffentlichungsnummer:
**WO 2003/084052 (09.10.2003 Gazette 2003/41)**

# (54) DEMODULATION EINES DIGITAL FREQUENZMODULIERTEN ANALOGEN EMPFANGSSIGNALS DURCH AUSWERTUNG DER ZEITLICHEN ABSTÄNDE ZWISCHEN DEN NULLDURCHGÄNGEN

DEMODULATION OF A DIGITALLY FREQUENCY MODULATED ANALOGUE RECEIVED SIGNAL BY EVALUATION OF THE TIME DIFFERENCE BETWEEN THE NULL TRANSITIONS

DEMODULATION D'UN SIGNAL DE RECEPTION ANALOGIQUE MODULE EN FREQUENCE NUMERIQUEMENT PAR EVALUATION DES ECARTS TEMPORELS ENTRE LES PASSAGES PAR ZERO

(84) Benannte Vertragsstaaten:
**DE**

(30) Priorität: **02.04.2002 DE 10214581**

(43) Veröffentlichungstag der Anmeldung:
**29.12.2004 Patentblatt 2004/53**

(73) Patentinhaber: **Infineon Technologies AG**
**81669 München (DE)**

(72) Erfinder:
- **BRUECKMANN, Dieter**
**40670 Meerbusch (DE)**
- **NEUBAUER, André**
**47807 Krefeld (DE)**

(74) Vertreter: **Graf Lambsdorff, Matthias et al**
**Patentanwälte**
**Lambsdorff & Lange**
**Dingolfinger Strasse 6**
**81673 München (DE)**

(56) Entgegenhaltungen:
**EP-A- 0 529 986**
**US-A- 5 103 463**
**US-A- 5 355 092**

EP 1 490 962 B1

Anmerkung: Innerhalb von neun Monaten nach der Bekanntmachung des Hinweises auf die Erteilung des europäischen Patents kann jedermann beim Europäischen Patentamt gegen das erteilte europäische Patent Einspruch einlegen. Der Einspruch ist schriftlich einzureichen und zu begründen. Er gilt erst als eingelegt, wenn die Einspruchsgebühr entrichtet worden ist. (Art. 99(1) Europäisches Patentübereinkommen).

## Beschreibung

Die vorliegende Erfindung betrifft ein Verfahren zur Demodulation eines digital frequenzmodulierten analogen Empfangssignals in einem schnurlosen Kommunikationssystem wie Bluetooth, DECT, WDCT und dergleichen sowie eine Vorrichtung zu seiner Durchführung

Schnurlose digitale Kommunikationssysteme wie beispielsweise DECT, WDCT, Bluetooth, SWAP, WLAN IEEE802.11 benötigen zum drahtlosen Empfang der über die Luftschnittstelle gesendeten hochfrequenten Signale geeignete Empfänger, die in aufwandsgünstiger Weise dem Demodulator ein möglichst verzerrungsfreies Basisbandsignal liefern. Neben einer hohen Empfindlichkeit sind hierbei ein hoher Integrationsgrad, geringe Kosten, niedrige Stromaufnahme sowie Flexibilität hinsichtlich der Anwendbarkeit für verschiedene digitale Kommunikationssysteme erwünscht.

In heutigen Empfängerkonzepten für digital frequenzmodulierte Signale werden zur Demodulation und Signaldetektion klassische Signalverarbeitungsmethoden verwendet. Ein oftmals verwendetes Verfahren basiert auf dem sogenannten Limiter-Diskriminator-FM-Demodulator, bei dem nach einer harten Limitierung des im Allgemeinen komplexen Bandpass-Signals eine Demodulation des frequenzmodulierten Signals, z.B. durch einen analogen Koinzidenzdemodulator mit einer entsprechenden Detektion erfolgt.

Darüber hinaus gibt es Empfängerkonzepte, bei denen das Zwischenfrequenzsignal mit Hilfe eines A/D-Wandlers in den Digitalbereich umgesetzt wird und die Signaldetektion mit Hilfe von Methoden der digitalen Signalverarbeitung realisiert wird. Ein solches Verfahren ist beispielsweise in der DE 101 03 479.2 beschrieben, welche Stand der Technik nach § 3 Abs. 2 PatG darstellt. Gegenüber dem analogen Empfängerkonzept lassen sich mit einem derartigen Verfahren zwar qualitative Verbesserungen der Signaldetektion erzielen. Dieser Ansatz hat jedoch den Nachteil, dass ein aufwendiger A/D-Wandler erforderlich ist.

Die Druckschrift EP 0 529 986 A2 beschreibt einen FSK-Modulator und -Demodulator, welcher einen NulldurchgangsDetektor enthält, durch welchen die Nulldurchgänge eines mit mindestens zwei Signalfrequenzen codierten FSK-Signals detektiert werden. Der zeitliche Abstand zwischen den Nulldurchgängen wird gemessen und einer der beiden Signalfrequenzen, entsprechend einer der beiden digitalen Signaldaten, zugeordnet.

Die Druckschrift US 5,103,463 betrifft ebenfalls ein Verfahren und ein System zum Codieren und Decodieren von FSK-Signalen, bei welchem das Empfangssignal durch fortlaufendes Bestimmen der zeitlichen Abstände zwischen den Spitzenwerten oder den Nulldurchgängen demoduliert wird. Zusätzlich kann eine ermittelte Folge von Nulldurchgangs-Abständen mit einem Satz von gespeicherten Abstandsfolgen verglichen werden und diejenige gespeicherte Abstandsfolge mit der geringsten Distanz zu der ermittelten Abstandsfolge als Detektionsergebnis ausgegeben werden.

Es ist demzufolge Aufgabe der vorliegenden Erfindung, ein verbessertes Demodulationsverfahren für digital frequenzmodulierte Empfangssignale in einem schnurlosen Kommunikationssystem anzugeben, mit welchem eine hohe Leistungsfähigkeit bei gleichzeitig niedrigem Realisierungsaufwand erzielt werden kann.

Diese Aufgabe wird durch die Merkmale der unabhängigen Patentansprüche 1 und 5 gelöst. Vorteilhafte Weiterbildungen und Ausgestaltungen sind in den Unteransprüchen angegeben.

Anhand von Fig. 1 wird zunächst das erfindungsgemäße Prinzip näher erläutert.

Fig. 1 entspricht Bild 11.2.3 auf Seite 385 des Buches "Nachrichtenübertragung" von K. D. Kammeyer, B. G. Teubner Verlag, Stuttgart, 1996, Kap. 11.2.1, und zeigt im unteren Teilbild eine frequenzmodulierte Trägerschwingung, während im oberen Teilbild die unmodulierte Trägerschwingung dargestellt ist. Die Modulationsart ist in diesem Beispiel eine zweistufige diskrete Frequenzmodulation (FSK, Frequency Shift Keying), also eine Frequenzumtastung zwischen zwei definierten Frequenzen aufgrund eines zweistufigen Datensignals. Es sind vier Datensignalperioden mit einer Datenfolge d = [1 -1 1 1] gezeigt, wobei jede Datenperiode eine Periodendauer T aufweist. Im vorliegenden Fall beträgt die Trägerfrequenz $f_0$ = 2,5/T und der Modulationsindex $\eta$ = 1. Die Phase der Schwingung verläuft kontinuierlich (CPFSK, Continuous Phase FSK). Falls sich an den Übergängen zwischen den Datenperioden das Datensignal ändert, so findet ein diskreter Frequenzsprung statt. In den meisten Fällen ist die Modulation bandbegrenzt, so dass die Frequenzsprünge nicht rechteckförmig sondern zeitlich ausgedehnt erfolgen. Ein Beispiel hierfür ist das Gaussian-Minimum-Shift-Keying (GMSK), welches beispielsweise im paneuropäischen Mobilfunkstandard GSM (Global System for Mobile Communications) zum Einsatz kommt. Die Frequenz der unmodulierten Trägerschwingung (oberes Teilbild) liegt zwischen den den Datensignalen entsprechenden diskreten Frequenzen.

Das erfindungsgemäße Prinzip beruht darauf, dass Datenperioden, welche verschiedene Datensignale repräsentieren, verschiedene zeitliche Abstände zwischen den Nulldurchgängen aufweisen. Im vorliegenden Beispiel der Fig. 1 weisen die Datenperioden, die das Datensignal 1 beinhalten, sechs Nulldurchgänge auf, während Datenperioden, die das Datensignal -1 beinhalten vier Nulldurchgänge zeigen. Dies hat zur Folge, dass die zeitlichen Abstände zwischen den Nulldurchgängen zwischen voneinander verschiedenen Datensignalen unterschiedlich sind. Zum Zwecke der Demodulation können somit die zeitlichen Abstände zwischen den Nulldurchgängen ermittelt und zur Detektion der digitalen Signaldaten genutzt werden. Dies kann im Prinzip direkt am Empfangssignal durchgeführt werden. Es ist jedoch ebenso möglich, dieses Verfahren an einem aus dem

Empfangssignal erzeugten Zwischenfrequenzsignal durchzuführen. In einem praktischen Ausführungsbeispiel kann es sich dabei um ein Zwischenfrequenzsignal handeln, welches von einem Limiter ausgegeben wird und im Folgenden nur noch als Limiterausgangssignal bezeichnet wird.

Das Signal, in welchem die zeitlichen Abstände von Nulldurchgängen bestimmt werden sollen, kann einem Detektor für Nulldurchgänge zugeführt werden, in welchem es in ein rechteckförmiges Signal umgesetzt wird, dessen Nulldurchgänge bestimmt werden. Der zeitliche Abstand zwischen den Nulldurchgängen des rechteckförmigen Signals wird zur Signaldetektion genutzt. Mit dem Detektor für Nulldurchgänge kann ein Zähler verbunden sein, welcher Impulse zählt, die ihm mit einer vorgegebenen Taktfrequenz $f_0$ zugeführt werden. Bei jedem Nulldurchgang wird dem Zähler ein Rücksetzimpuls zugeführt und bevor der Zähler zurückgesetzt wird, wird der erreichte Zählerstand ausgegeben und in ein den Abstand der vorangegangenen Nulldurchgänge repräsentierendes Signal umgesetzt.

Die Erfindung ist nicht auf 2-stufige digitale Frequenzmodulation beschränkt, wie sie beispielsweise in Fig. 1 dargestellt ist. Vielmehr kann sie ebenso auch auf mehrstufige digitale Frequenzmodulation angewandt werden, bei welcher jeweils eine Mehrzahl von Bits des ursprünglichen zu übertragenden digitalisierten Signals auf ein Datensignal abgebildet wird. Beispielsweise kann die Frequenzmodulation 4-stufig (4-FSK) sein, wobei 2 Bits des eingehenden Bit-Datenstroms auf ein Datensignal abgebildet werden, oder sie kann 8-stufig (8-FSK) sein, wobei 3 Bits des eingehenden Bit-Datenstroms auf ein Datensignal abgebildet werden. Bei diesen mehrstufigen Frequenzmodulationsverfahren erhält man bei Anwendung des erfindungsgemäßen Verfahrens eine der Anzahl der Frequenzen entsprechende Anzahl verschiedener Nulldurchgangsabstände. Das Verfahren und die Vorrichtung zu seiner Durchführung müssen in der Lage sein, die Nulldurchgangsabstände richtig zu detektieren und der richtigen Frequenz und somit dem richtigen Datensignal zuzuordnen.

Prinzipiell ist es möglich, die Datensignale und somit die gesendeten Bits jeweils aus nur einem gemessenen Nulldurchgangsabstand der Datensignalperiode T zu bestimmen, indem im Abstand der Datensignalperiode die Werte des Nulldurchgangsabstands mit einem Referenzwert (bei 2-FSK) verglichen werden. Ist der Nulldurchgangsabstand größer als der Referenzwert, so wurde in dem betreffenden zeitlichen Intervall mit der niedrigen Frequenz gesendet, ist er kleiner wurde entsprechend mit der höheren Frequenz gesendet. Bei 2-stufig FSK-modulierten Signalen korrespondieren diese Frequenzen zu den Bits 1 und 0 bzw. den Datensignalen 1 und - 1. Wird jeweils nur ein Wert des Nulldurchgangsabstands pro Datensignalperiode benutzt, so ist das Demodulationsverfahren zwar sehr einfach implementierbar, erweist sich aber als relativ empfindlich gegenüber Störungen, z.B. weißem Rauschen, das in einem realen System immer dem Nutzsignal überlagert ist.

Das Verfahren wird weitaus robuster gegenüber derartigen Störungen, wenn mehrere aufeinander folgende Nulldurchgänge für die Detektion genutzt werden. Diese können beispielsweise in einer Schieberegisterkette abgespeichert werden. Der Einfluss eines Bits auf die Sendefrequenz ist insbesondere bei gefilterten frequenzmodulierten Empfangssignalen (z.B. GMSK, Gaussian Minimum Shift Keying) über mehrere Bitperioden verteilt. Entsprechend ist es sinnvoll, alle Nulldurchgänge in diesem größeren zeitlichen Intervall zur Erkennung des zugehörigen Bits zu nutzen. Es können somit eine Mehrzahl von aufeinander folgenden Nulldurchgangsabständen über mehrere Datensignalperioden bestimmt und aus diesen die entsprechenden Datensignale detektiert werden.

Ferner kann eine solchermaßen ermittelte Abstandsfolge mit einem Satz von abgespeicherten Abstandsfolgen verglichen werden und es kann diejenige abgespeicherte Abstandsfolge ermittelt werden, welche die kleinste Distanz zu der detektierten Abstandsfolge aufweist. Anschließend können dann die dieser abgespeicherten Abstandsfolge entsprechenden Datensignale ausgegeben werden.

Die Distanz zwischen der ermittelten Abstandsfolge $x_1 \ldots x_N$ und den gespeicherten Abstandsfolgen $y_1 \ldots y_N$ kann nach der Beziehung

$$d(x, y) = \sqrt[g]{\sum_{n=1}^{N} \left| x_n - y_n \right|^g}$$

mit $1 \leq g < \infty$ ermittelt werden.

Das erfindungsgemäße Demodulationsverfahren ist Teil eines Verfahrens zum Empfang und zur Verarbeitung eines digital frequenzmodulierten analogen Empfangssignals. Dieses Empfangs- und Verarbeitungsverfahren kann zur Verbesserung der Qualität und Leistungsfähigkeit des Demodulationsverfahrens in einer weiteren Ausführungsform dahingehend verbessert werden, dass die Empfindlichkeit des Empfangssystems gegenüber Frequenzoffsets verringert wird. Ein derartiger Frequenzoffset kann sich zum Beispiel zwischen einer im Sender zum Hochmischen auf eine Trägerfrequenz verwendeten Mischfrequenz und der zum Heruntermischen verwendeten Mischfrequenz des Empfängers einstellen oder von Anfang an zwischen diesen vorhanden sein. Anfänglich gleiche Zwischenfrequenzen von Sender und Empfänger können infolge einer Drift einer oder beider Zwischenfrequenzen einen Frequenzoffset hervorrufen. Entsprechend der Standards für schnurlose Kommunikationssysteme wie DECT, WDCT, Bluetooth usw. sind Frequenzoffsets in einem gewissen Toleranzbereich durchaus zugelassen. Gemäß den Bluetooth-Spezifikationen können sich diese

Frequenzoffsets beispielsweise innerhalb eines Bereiches von ± 75 kHz bewegen. Simulationstechnische Untersuchungen haben gezeigt, dass es infolge dieser Frequenzoffsets ohne Vornahme geeigneter Gegenmaßnahmen bei dem wie oben beschriebenen Demodulationsverfahren zu einem Verlust an Empfindlichkeit um bis zu 6 dB kommen kann. Wünschenswert ist es daher, ein geeignetes Verfahren zur Erkennung eines Frequenzoffsets und eine entsprechende Offset-Kompensation anzugeben. In einer weiteren Ausführungsform wird vor dem Start des Demodulationsverfahrens ein gegebenenfalls vorhandener Frequenzoffset des Empfangssignals dadurch ermittelt, dass von einer Anzahl ermittelter Nulldurchgangsabstände des Empfangssignals ein Mittelwert ermittelt und mit einem erwarteten Mittelwert des nicht-frequenzverschobenen Empfangssignals (oder des Zwischenfrequenzsignals) verglichen wird und anschließend aus der Differenz der Mittelwerte der Frequenzoffset bestimmt wird. Diese Ausführungsform des Verfahrens ist auch auf die Erkennung und Kompensation von Frequenzoffsets bei Zwischenfrequenzsignalen anwendbar, die sich wie oben erwähnt zwischen Sender und Empfänger einstellen können. Eine Kompensation des Frequenzoffsets kann beispielsweise derart erfolgen, dass bereits vorab nicht nur ein einzelner Satz sondern eine Mehrzahl von Sätzen von Abstandsfolgen abgespeichert werden und dass in Abhängigkeit von dem ermittelten Frequenzoffset ein bestimmter Satz von Abstandsfolgen ausgewählt wird, mit welchem die ermittelten Abstandsfolgen zu vergleichen sind. Hierbei handelt es sich also um eine Art von diskreter Kompensation, bei welcher vorab der Toleranzbereich der Frequenzoffsets in Intervalle aufgeteilt wird und jedem Intervall ein abgespeicherter Satz von Abstandsfolgen zugeordnet wird. Alternativ dazu ist jedoch ebenso eine kontinuierliche Kompensation des Frequenzoffsets denkbar, bei welcher beispielsweise ein einzelner Satz von abgespeicherten Abstandsfolgen auf der Basis des ermittelten Frequenzoffsets modifiziert wird.

Wenn der Vielfachzugriff in dem Sende- und Empfangssystem ganz oder teilweise durch ein Zeitmultiplexverfahren (TDMA, Time Division Multiple Access) ermöglicht wird, so weist das Empfangs- und Verarbeitungsverfahren in der Regel einen Verfahrensschritt des Synchronisierens des Empfängers mit einer Zeitschlitzstruktur des Empfangssignals auf. Es ist dabei von Vorteil, wenn die vorstehend beschriebene Ermittlung des Frequenzoffsets vor dem Verfahrensschritt des Synchronisierens erfolgt. Zu diesem Zweck kann der ermittelte Frequenzoffset einer Vergleichereinheit zugeführt werden, in welcher eine einer Anzahl verschiedener Frequenzoffsets entsprechende Anzahl, den Frequenzoffsets zugeordneter Synchronisations-Codefolgen abgespeichert ist, und eine Synchronisations-Codefolge entsprechend dem zugeführten Frequenzoffset ausgewählt wird. Der eigentliche Verfahrensschritt des Synchronisierens besteht dann darin, dass kontinuierlich eine Mehrzahl von aufeinander folgenden Nulldurchgangsabständen des Empfangssignals in einer Speichereinheit gespeichert und in der Vergleichereinheit mit der ausgewählten Synchronisations-Codefolge verglichen wird, bis eine Übereinstimmung zwischen einer ermittelten Abstandsfolge und einer der Synchronisations-Codefolge entsprechenden Abstandsfolge festgestellt wird. Wenn dies erfolgt ist, so ist die Synchronisation erfolgreich beendet und es kann ein Abtastzeitpunkt festgelegt werden.

Eine weitere Ausführungsform des erfindungsgemäßen Verfahrens bezieht sich darauf, dass bei Verwendung eines Zeitmultiplexverfahrens im unsynchronisierten Zustand des Systems eine Synchronisation über den gesamten Zeitrahmen möglich sein muss. Wenn die Synchronisiereinheit über den gesamten Zeitrahmen aktiv ist, so kann es relativ häufig passieren, dass eine Synchronisation auf ein Rauschsignal am Eingang erfolgt. Es ist somit wünschenswert, zu erkennen, wann Nutzsignale und wann ausschließlich Störsignale am Eingang anliegen. Die weitere Ausführungsform stellt anhand des Mittelwertes und/oder der Streuung der ermittelten Nulldurchgangsabstände fest, ob das Empfangssignal Nutzdaten enthält oder ein Störsignal darstellt. Liegt nämlich ein FSKmoduliertes, insbesondere GMSK-moduliertes, Nutzsignal am Empfängereingang an, so bewegen sich die Abstände der Nulldurchgänge in einem bestimmten Bereich. Dieses gilt auch dann, wenn das Signal rauschbehaftet ist. Liegt jedoch am Eingang des Empfängers ein reines Störsignal, also beispielsweise weißes Rauschen an, so streuen die Abstände der Nulldurchgänge über einen weitaus größeren Bereich. Aus den Extremwerten der Abstände der Nulldurchgänge kann also ein Nutzsignal von einem Rauschsignal unterschieden werden. Als weiteren Indikator für die Nutzdaten kann wie beschrieben der Mittelwert über die zurückliegenden Abstände der Nulldurchgänge ausgewertet werden. Insbesondere kann ermittelt werden, ob der Mittelwert der Nulldurchgangsabstände innerhalb eines vorgegebenen Bereichs liegt und/oder die Einzelwerte der Nulldurchgangsabstände mehrheitlich innerhalb eines vorgegebenen Bereichs liegen. Im letzteren Fall müsste nicht nur der Wertebereich vorgegeben werden sondern auch eine quantitative Bedingung für die mehrheitliche Häufung innerhalb dieses vorgegebenen Bereichs.

Die vorstehend beschriebenen Ausführungsformen des erfindungsgemäßen Verfahrens können in beliebiger Weise miteinander kombiniert werden. Insbesondere kann praktischer Weise ein bei der Ermittlung eines Frequenzoffsets ermittelter Mittelwert von Nulldurchgangsabständen gleichermaßen für die vorstehend beschriebene Nutzdatenerkennung herangezogen werden.

Ebenso kann während dem Verfahrensschritt des Synchronisierens der in einer Synchronisiereinheit verwendeten Speichereinheit zum kontinuierlichen Abspeichern einer Mehrzahl von aufeinander folgenden Nulldurchgangsabständen des Empfangssignals ein Rücksetzsignal zugeführt werden, falls festgestellt wird, dass das Empfangssignal ein Störsignal darstellt.

Eine erfindungsgemäße Vorrichtung zur Demodulation eines digital frequenzmodulierten analogen Empfangssignals in einem schnurlosen Kommunikationssystem weist in seiner allgemeinsten Form einen Detektor für Nulldurchgänge und eine mit diesem verbundene Einrichtung zur Bestimmung der zeitlichen Abstände der Nulldurchgänge auf.

Die Einrichtung zur Bestimmung der Nulldurchgangsabstände kann einen Zähler umfassen, welcher einen Taktimpulseingang und einen Rücksetzimpulseingang und einen Ausgang aufweist, wobei ein Taktimpulsgeber mit dem Taktimpulseingang verbunden ist und der Detektor für Nulldurchgänge mit dem Rücksetzimpulseingang verbunden ist.

Die Einrichtung zur Bestimmung der Nulldurchgangsabstände kann mit einem Schieberegister zum Abspeichern einer Folge von Nulldurchgangsabständen in digitaler Form verbunden sein. Das Schieberegister kann mit einer Klassifizierungseinrichtung verbunden sein, welche eine Speichereinrichtung zur Speicherung eines Satzes von Abstandsfolgen und einer Distanzberechnungseinrichtung zur Berechnung der Distanz zwischen der ermittelten Abstandsfolge und den gespeicherten Abstandsfolgen aufweist. Die Distanzberechnungseinrichtung kann derart ausgelegt oder programmiert sein, dass sie die Distanz zwischen der ermittelten Abstandsfolge $x_1...x_N$ und den gespeicherten Abstandsfolgen $y_1...y_N$ nach der oben bereits genannten Beziehung ermittelt.

Die erfindungsgemäße Vorrichtung kann Teil einer Vorrichtung zum Empfang und zur Verarbeitung eines digital frequenzmodulierten analogen Empfangssignals sein.

Diese umfassendere Vorrichtung kann ferner eine Frequenzoffset-Erkennungseinheit aufweisen, welcher die ermittelten Nulldurchgangsabstände zuführbar sind, und welche für eine Mittelwertbildung über eine vorbestimmte Anzahl von Nulldurchgangsabständen und einen Vergleich des gebildeten mit einem erwarteten Mittelwert und für eine darauf basierende Frequenzoffset-Erkennung ausgebildet ist.

Die Frequenzoffset-Erkennungseinheit kann ferner für die Auswahl eines Satzes aus mehreren Sätzen abgespeicherter Abstandsfolgen auf der Basis des ermittelten Frequenzoffsets ausgebildet sein. Wie bereits oben beschrieben, können für die Zwecke einer diskreten Frequenzoffset-Kompensation mehrere Sätze von Abstandsfolgen vorab abgespeichert und vorgegebenen Intervallen des Frequenzoffsets zugeordnet sein. Falls jedoch eine kontinuierliche Kompensation des Frequenzoffsets gewünscht wird, so kann alternativ hierzu die Frequenzoffset-Erkennungs- und Kompensationseinheit ebenso für die Modifikation des einen Satzes abgespeicherter Abstandsfolge ausgebildet sein.

Die Empfangs- und Verarbeitungsvorrichtung eines digital frequenzmodulierten analogen Empfangssignals kann bei Verwendung eines Zeitmultiplexverfahrens ferner eine Synchronisiereinheit zum Synchronisieren des Empfängers mit einer Zeitschlitzstruktur des Empfangssignals aufweisen.

Die Synchronisiereinheit kann dabei eine Speichereinheit zum kontinuierlichen Speichern einer Mehrzahl von aufeinander folgenden Nulldurchgangsabständen des Empfangssignals und eine mit der Frequenzoffset-Erkennungseinheit verbundene Vergleichereinheit aufweisen, in welcher eine einer Anzahl verschiedener Frequenzoffsets entsprechende Anzahl den Frequenzoffsets jeweils zugeordneter Synchronisations-Codefolgen abgespeichert ist, wobei die Vergleichereinheit für die Auswahl einer dem zugeführten Frequenzoffset entsprechenden Synchronisations-Codefolge und für die Feststellung der Übereinstimmung dieser Synchronisations-Codefolge mit einer in der Speichereinheit abgespeicherten Abstandsfolge ausgebildet ist.

Die Empfangsvorrichtung kann ferner eine Nutzdaten-Erkennungseinheit aufweisen, welche dafür ausgebildet ist, anhand des Mittelwertes und/oder der Streuung der ermittelten Nulldurchgangsabstände festzustellen, ob das Empfangssignal Nutzdaten enthält oder ein Störsignal darstellt.

Die vorstehend genannte Nutzdaten-Erkennungseinheit kann mit der Frequenzoffset-Erkennungseinheit verbunden sein und die Frequenzoffset-Erkennungseinheit kann für eine Übermittlung eines von ihr ermittelten Mittelwertes der Nulldurchgangsabstände an die Nutzdaten-Erkennungseinheit ausgebildet sein.

Die Nutzdaten-Erkennungseinheit kann ferner mit der in der Synchronisiereinheit enthaltenen Speichereinheit verbunden sein und kann dafür ausgebildet sein, an die Speichereinheit ein Rücksetzsignal abzugeben, falls sie festgestllt hat, dass das Empfangssignal ein Störsignal darstellt.

Im Folgenden wird die vorliegende Erfindung anhand der Zeichnungsfiguren noch näher erläutert.

Es zeigen:

Fig. 1 eine digital frequenzmodulierte Trägerschwingung (unteres Teilbild) zusammen mit einer unmodulierten Trägerschwingung (oberes Teilbild);

Fig. 2A die Wirkungsweise eines Detektors für Nulldurchgänge;

Fig. 2B die Verwendung eines Detektors für Nulldurchgänge für die erfindungsgemäße Demodulation;

Fig. 3 eine Synchronisiereinheit als Teil einer erfindungsgemäßen Vorrichtung;

Fig. 4 eine mit einer Nutzdaten-Erkennungseinheit zusammenwirkende Synchronisiereinheit als Teil einer erfindungsgemäßen Vorrichtung.

In der Fig. 2A ist bereits das Prinzip des Verfahrens zur Demodulation von FM-modulierten Signalen angedeutet. Das analoge Empfangssignal, das sich im Zwischenfrequenzbereich befindet, wird mit Hilfe des Nulldurchgangsdetektors 1 in ein rechteckförmiges Signal umgesetzt, dessen Nulldurchgänge auszuwerten sind. Der zeitliche Abstand $D_i$ zwischen den Nulldurchgängen des rechteckförmigen Signals kann zur Signaldetektion genutzt werden.

In der Fig. 2B ist ein Ausführungsbeispiel für eine erfindungsgemäße Vorrichtung bzw. einen Demodulator oder Detektor dargestellt. Das analoge, FM-modulierte Zwischenfrequenzsignal stellt das Eingangssignal des Nulldurchgangsdetektors 1 dar. Dieses Eingangssignal kann beispielsweise das Ausgangssignal eines Limiters sein. Das Eingangssignal des Nulldurchgangsdetektors wird in ein Signal t_d umgesetzt, das bei jedem Nulldurchgang einen Rücksetzimpuls für einen Zähler 2 erzeugt. Der Zähler 2 zählt Taktimpulse, die ihm mit einer konstanten Frequenz $f_0$ zugeführt werden. Bevor der Zähler 2 zurückgesetzt wird, wird der erreichte Zählerstand ausgegeben und in ein Signal t_delta umgesetzt, das die zeitlichen Abstände zwischen aufeinander folgenden Nulldurchgängen angibt. Diese Werte t_ delta werden in einer Schieberegisterkette 3 abgespeichert. Eine bestimmte Anzahl von Werten t_delta kann zur Erkennung der entsprechenden Bitfolge $d_i$ genutzt werden.

Wie bereits oben erwähnt, wird das Demodulationsverfahren weitaus robuster gegenüber Störungen, wenn mehrere aufeinander folgende Nulldurchgänge für die Detektion genutzt werden. Diese können in der Schieberegisterkette 3 abgespeichert werden, wie in der Fig. 2B dargestellt ist. Insbesondere bei Verwendung von bandbegrenzter Frequenzmodulation wie GMSK (Gaussian Minimum Shift Keying) ist der Einfluss eines Bits, also eines Datensignals auf die Sendefrequenz über mehrere Bitperioden oder Datensignalperioden verteilt. Entsprechend ist es sinnvoll, alle Nulldurchgänge in diesem größeren zeitlichen Intervall zur Erkennung des zugehörigen Bits zu nutzen. Als Beispiel sei ein Bluetooth-System mit einem Modulationsindex $\eta$ von 0,315 genannt, bei welchem ein Bit die Sendefrequenz über ein zeitliches Intervall von 5 Bitperioden beeinflusst. Bei einer Zwischenfrequenz von 1 MHz beträgt die Anzahl der Nulldurchgänge in diesem zeitlichen Intervall ca. 16. Es ist daher sinnvoll, 16 Werte für die Erkennung eines Bits heranzuziehen, wie in der Fig. 2B dargestellt ist. Diese 16 Nulldurchgänge werden allerdings nicht nur von dem zu detektierenden Bit bestimmt, sondern auch von den beiden vorhergehenden und den beiden nachfolgenden Bits. Es ist daher sinnvoll, aus den aufeinander folgenden Nulldurchgängen nicht nur 1 Bit sondern eine Bitfolge zu bestimmen. In diesem konkreten Fall lassen sich aus den 16 Nulldurchgängen 5 aufeinander folgende Bits bestimmen.

Die Erkennung erfolgt mit Hilfe einer Klassifizierungseinrichtung 4, die die Distanz der jeweils ermittelten und in der Schieberegisterkette 3 abgespeicherten Abstandsfolge mit den abgespeicherten Abstandsfolgen bestimmt, die in einem Speicher abgelegt wurden und nachfolgend auch als Trainingspattern bezeichnet werden. Die abgespeicherten Abstandsfolgen ergeben sich aus den Abstandsfolgen der Nulldurchgänge für alle möglichen Bitfolgen. Werden also 5 aufeinander folgende Bits betrachtet, so ergeben sich $2^5 = 32$ mögliche Bitkombinationen und damit Abstandsfolgen, die als abzuspeichernde Abstandsfolgen in den Speicher abgelegt werden müssen. Die Bitfolge, die einer abgespeicherten Abstandsfolge mit der geringsten Distanz zur detektierten Abstandsfolge der Werte t_delta zugeordnet ist, wird als Ausgangsbitfolge $d_i$ detektiert. Wird dieser Vergleich jeweils im Abstand einer Bitperiode durchgeführt, so liegen insgesamt 5 Ergebnisse für jedes Bit vor. Die Klassifizierungseinrichtung 4 bestimmt dann aufgrund einer Mehrheitsentscheidung das detektierte Bit. Die abgespeicherten Abstandsfolgen können unter Berücksichtigung systematischer Fehler auf dem Übertragungskanal bestimmt werden, so dass diese Fehler kompensiert werden können.

Um den Empfänger unempfindlicher gegenüber zeitlichen Verzögerungen auf der Funkstrecke zu machen, bietet es sich an, den Mustervergleich mit den abgespeicherten Abstandsfolgen zusätzlich mit den benachbarten Datenpattern durchzuführen. Für das konkrete Ausführungsbeispiel in der Fig. 2B bedeutet das, dass die Schieberegisterkette 3 auf 18 Werte erweitert wird. Es werden dann die 3 Datenpattern in den Verzögerungselementen 1-15, 2-16 und 3-17 für den Vergleich herangezogen. Die Bitfolge, die der abgespeicherten Abstandsfolge mit der geringsten Distanz zur detektierten Folge der Werte t_delta zugeordnet ist, wird wieder als Ausgangsbitfolge $d_i$ detektiert.

Eine gängige Methode, um den Abstand zwischen dem Datenpattern und den Trainingspattern zu bestimmen, ist die Berechnung der euklidischen Abstandsnorm gemäß folgender Beziehung:

$$d(x, y) = \sqrt[g]{\sum_{n=1}^{N} |x_n - y_n|^g}$$

mit g = 2.

Die Berechnung der euklidischen Abstandsnorm ist im Rahmen der Erfindung denkbar, jedoch relativ aufwendig, da eine Reihe von Multiplikationen ausgeführt werden müssen. Weitaus einfacher lässt sich die sogenannte "City-Block-Distanz" berechnen, die sich aus obiger Beziehung für g = 1 ergibt und keine Multiplikationen erfordert. Die Untersuchungen haben gezeigt, dass bei Verwendung der City-Block-Distanz bei dem beschriebenen Verfahren keine Einbußen in der Leistungsfähigkeit des Demodulationsverfahrens entstehen.

Die in Fig. 2B dargestellte Vorrichtung kann Teil eines Empfängers sein. Falls ein Zeitmultiplexverfahren verwendet wird, weist der Empfänger eine Synchronisiereinheit auf, um den Empfänger mit der Zeitschlitzstruktur des Empfangssignals zeitlich zu synchronisieren.In der Fig. 3 ist ein Blockschaltbild einer derartigen Synchronisiereinheit dargestellt. Diese Synchronisiereinheit 6 ist mit einer Frequenzoffset-Erkennungseinheit 5 verbunden. Die Frequenzoffset-Erkennungseinheit 5 ist ein Funktionsblock, in welchem aus einer Anzahl von Nulldurchgangsabständen t_delta ein Mittelwert gebildet wird und dieser Mittelwert mit einem erwarteten und gespeicherten Mittelwert verglichen wird. Simulationen haben gezeigt, dass die Empfindlichkeit des Empfängers bei größeren Frequenzoffsets stark abnimmt. Es ist daher äußerst vorteilhaft, wenn bereits während des Synchronisiervorgangs eine Frequenzoffset-Erkennung erfolgt, so dass die Synchronisations-Codefolgen für die Klassifizierung entsprechend dem ermittelten Frequenzoffset ausgewählt werden können. Betrachtet sei als konkretes Ausführungsbeispiel ein Bluetooth-Empfänger mit einer Zwischenfrequenz von 1 MHz, so zeigt sich, dass der Einfluss des Frequenzoffsets auf die Empfängerempfindlichkeit praktisch vernachlässigbar ist, wenn die Kompensation des Frequenzoffsets in diskreter Weise in folgenden Intervallen erfolgt:
-75 kHz, -50 kHz, -25 kHz,
0, 15 kHz, 30 kHz, 45 kHz, 60 kHz, 75 kHz.

Entsprechend dieser Intervalle für den Frequenzoffset sind in einer Vergleichereinrichtung 6a der Synchronisiereinrichtung 6 insgesamt 8 Sätze von Synchronisations-Codefolgen abgespeichert. Wenn durch die Frequenzoffset-Erkennungseinheit 5 der Frequenzoffset ermittelt worden ist, wird er von dieser Einheit an die Vergleichereinheit 6a übermittelt bzw. es wird festgestellt, innerhalb welchem Intervall sich der Frequenzoffset befindet und entsprechend wird der diesem Intervall zugeordnete Satz von Synchronisations-Codefolgen in der Vergleichereinheit 6a ausgewählt. In der Speichereinheit 6b werden kontinuierlich Nulldurchgangsabstände t_delta in einer Schieberegisterkette abgespeichert und nach jedem Eingang eines weiteren Nulldurchgangsabstands und dem entsprechenden Verschieben der anderen bereits gespeicherten Nulldurchgangsabstände wird ein Vergleich mit der vorab aufgrund des Frequenzoffsets ausgewählten Synchronisations-Codefolge vorgenommen. Im vorliegenden Fall wird angenommen, dass die Synchronisations-Codefolge 80 Nulldurchgänge aufweist. Sobald die Synchronisations-Codefolge positiv detektiert worden ist, ist die Synchronisation erfolgreich beendet und die Vergleichereinheit 6a legt auf dieser Basis einen Abtastzeitpunkt fest.

In der Fig. 4 ist eine weitere Ausführungsform der erfindungsgemäßen Vorrichtung gemäß der Fig. 3 dargestellt, wobei letztere Vorrichtung um eine Nutzdaten-Erkennungseinheit 7 erweitert worden ist. Der Nutzdaten-Erkennungseinheit 7 werden die Nulldurchgangsabstände (von dem Detektor 1) zugeführt. Ebenso wird der Nutzdaten-Erkennungseinheit 7 der von der Frequenzoffset-Erkennungseinheit 5 ermittelte Mittelwert der Nulldurchgangsabstände übermittelt. Diese stellt daraufhin fest, ob es sich bei dem Empfangssignal um Nutzdaten oder um ein Störsignal handelt. Wenn Letzteres der Fall ist, führt die Nutzdaten-Erkennungseinheit 7 der Speichereinheit 6a ein Rücksetzsignal zu, so dass in der in der Speichereinheit 6a enthaltenen Schieberegisterkette eventuell bereits gespeicherte Nulldurchgangsabstände auf Null zurückgesetzt werden.

## Patentansprüche

**1.** Verfahren zur Demodulation eines digital frequenzmodulierten analogen Empfangssignals in einem schnurlosen Kommunikationssystem, bei welchem

- die zeitlichen Abstände zwischen den Nulldurchgängen des Empfangssignals oder eines aus dem Empfangssignal erzeugten Zwischenfrequenzsignals ermittelt und zur Detektion der digitalen Signaldaten oder Bits genutzt werden, wobei
- eine Mehrzahl von zeitlichen Abständen zwischen aufeinander folgenden Nulldurchgängen ermittelt wird, die solchermaßen ermittelte Abstandsfolge mit einem Satz von abgespeicherten Abstandsfolgen verglichen wird, diejenige abgespeicherte Abstandsfolge ermittelt wird, die die kleinste Distanz zu der ermittelten Abstandsfolge aufweist, und die dieser abgespeicherten Abstandsfolge zugeordnete Anzahl M von digitalen Signaldaten bestimmt wird, wobei $M \geq 2$ ist,

**dadurch gekennzeichnet, dass**

- der Vergleich der ermittelten Abstandsfolge mit dem Satz von abgespeicherten Abstandsfolgen zeitlich aufeinander folgend jeweils im Abstand einer Signaldatenperiode oder Bit-Periode erneut durchgeführt wird, sodass für jede Bit-Position M Detektionsergebnisse erzielt werden, und
- aus den M Detektionsergebnissen durch eine Mehrheitsentscheidung ein endgültiges Detektionsergebnis für die jeweilige Bit-Position bestimmt wird.

**2.** Verfahren nach Anspruch 1,
**dadurch gekennzeichnet, dass**

- ein Zähler (2) Impulse zählt, die ihm mit einer vorgegebenen Frequenz ($f_0$) zugeführt werden,
- bei jedem Nulldurchgang dem Zähler (2) ein Rücksetzimpuls zugeführt wird, und
- bevor der Zähler (2) zurückgesetzt wird, der

erreichte Zählerstand ausgegeben und in ein den Abstand der vorangegangenen Nulldurchgänge repräsentierendes Signal umgesetzt wird.

**3.** Verfahren nach Anspruch 1 oder 2,
**dadurch gekennzeichnet, dass**

- die Distanz zwischen der ermittelten Abstandsfolge $x_1...x_N$ und den gespeicherten Abstandsfolgen $y_1...y_N$ nach der Beziehung

$$d(x, y) = \sqrt[g]{\sum_{n=1}^{N} |x_n - y_n|^g}$$

mit $1 \leq g < \infty$ ermittelt wird.

**4.** Verfahren zum Empfang und zur Verarbeitung eines digital frequenzmodulierten analogen Empfangssignals, umfassend ein Demodulationsverfahren nach einem oder mehreren der vorhergehenden Ansprüche.

**5.** Vorrichtung zur Demodulation eines digital frequenzmodulierten analogen Empfangssignals in einem schnurlosen Kommunikationssystem, mit

- einem Detektor (1) für Nulldurchgänge, und
- einer mit dem Detektor (1) für Nulldurchgänge verbundene Einrichtung (2) zur Bestimmung der zeitlichen Abstände der Nulldurchgänge, wobei
- die Einrichtung (2) zur Bestimmung der Nulldurchgangsabstände mit einem Schieberegister (3) zum Abspeichern einer Folge von Nulldurchgangsabständen in digitaler Form verbunden ist, und
- das Schieberegister (3) mit einer Klassifizierungseinrichtung (4) verbunden ist, welche

  - eine Speichereinrichtung zur Speicherung eines Satzes von Abstandsfolgen und jeweils zugehöriger digitaler Signaldaten und
  - eine Distanzberechnungseinrichtung zur Berechnung der Distanz zwischen der ermittelten Abstandsfolge und den gespeicherten Abstandsfolgen aufweist,

**dadurch gekennzeichnet, dass**

- die Vorrichtung dafür ausgelegt ist, den Vergleich der ermittelten Abstandsfolge mit dem Satz von abgespeicherten Abstandsfolgen zeitlich aufeinander folgend jeweils im Abstand einer Signaldatenperiode oder Bit-Periode erneut durchzuführen, sodass für jede Bit-Position M Detektionsergebnisse erzielt werden, und
- die Klassifizierungseinrichtung (4) dafür ausgelegt ist, aus den M Detektionsergebnissen durch eine Mehrheitsentscheidung ein endgültiges Detektionsergebnis für die jeweilige Bit-Position zu bestimmen.

**6.** Vorrichtung nach Anspruch 5,
**dadurch gekennzeichnet, dass**

- die Einrichtung (2) zur Bestimmung der Nulldurchgangsabstände einen Zähler (2) umfasst, welcher einen Taktimpulseingang und einen Rücksetzimpulseingang und einen Ausgang aufweist, wobei
- ein Taktimpulsgeber mit dem Taktimpulseingang verbunden ist und der Detektor (1) für Nulldurchgänge mit dem Rücksetzimpulseingang verbunden ist.

**7.** Vorrichtung nach Anspruch 5 oder 6,
**dadurch gekennzeichnet, dass**

- die Distanzberechnungseinrichtung die Distanz zwischen der ermittelten Abstandsfolge $x_1...x_N$ und den gespeicherten Abstandsfolgen $y_1...y_N$ nach der Beziehung

$$d(x, y) = \sqrt[g]{\sum_{n=1}^{N} |x_n - y_n|^g}$$

mit $1 \leq g < \infty$ ermittelt wird.

**8.** Vorrichtung zum Empfang und zur Verarbeitung eines digital frequenzmodulierten analogen Empfangssignals, umfassend eine Vorrichtung zur Demodulation nach einem oder mehreren der Ansprüche 5 bis 7.

## Claims

**1.** Method for demodulation of a digitally frequency-modulated analogue received signal in a cordless communication system, in which

- the time intervals between the zero crossings of the received signal or of an intermediate-frequency signal which is produced from the received signal are determined and are used for detection of the digital signal data or bits, wherein
- a plurality of time intervals between successive zero crossings are determined, the interval sequence determined in this way is compared with a set of stored interval sequences, that stored interval sequence which is closest to the determined interval sequence is determined, and the number M of digital signal data items associated with this stored interval sequence is determined, by M ≥ 2

**characterized in that**

- the determined interval sequence is compared with the set of stored interval sequences repeatedly, successively in time, separated by one signal data period or bit period, such that M detection results are achieved for each bit position, and
- a final detection result is determined for the respective bit position by a majority decision from the M detection results.

**2.** Method according to Claim 1, **characterized in that**

- a counter (2) counts pulses which are supplied to it at a predetermined frequency ($f_0$),
- a reset pulse is supplied to the counter (2) on each zero crossing, and
- before the counter (2) is reset, the count that has been reached is emitted, and is converted to a signal which represents the interval between the previous zero crossings.

**3.** Method according to Claim 1 or 2, **characterized in that**

- the distance between the determined interval sequence $x_1 ... x_N$ and the stored interval sequences $y_1 ... y_N$ is determined using the relationship

$$d(x,y) = \sqrt[g]{\sum_{n=1}^{N} \left| x_n - y_n \right|^g}$$

where $1 \leq g < \infty$.

**4.** Method for reception and for processing of a digitally frequency-modulated analogue received signal, comprising a demodulation method according to one or more of the preceding claims.

**5.** Apparatus for demodulation of a digitally frequency-modulated analogue received signal in a cordless communication system, having

- a detector (1) for zero crossings, and
- a device (2) which is connected to the detector (1) for zero crossings, in order to determine the time intervals between the zero crossings, wherein
- the device (2) for determining the zero crossing intervals is connected to a shift register (3) for storing a sequence of zero crossing intervals in digital form, and
- the shift register (3) is connected to a classification device (4), which

  - has a storage device for storing a set of intervals sequences and respectively associated digital signal data, and
  - a distance calculation device for calculation of the distance between the determined interval sequence and the stored interval sequences,

**characterized in that**

- the apparatus is designed to carry out the comparison of the determined interval sequence with the set of stored interval sequences again, successively in time, in each case separated by one signal data period or bit period, such that M detection results are achieved for each bit position M, and
- the classification device (4) is designed to determine a final detection result for the respective bit position by a majority decision from M detection results.

**6.** Apparatus according to Claim 5, **characterized in that**

- the device (2) for determining the zero crossing intervals comprises a counter (2) which has a clock pulse input, a reset pulse input, and an output, wherein
- a clock pulse transmitter is connected to the clock pulse input, and the detector (1) for zero crossings is connected to the reset pulse input.

**7.** Apparatus according to Claim 5 or 6, **characterized in that**

- the distance calculation device determines the distance between the determined interval sequence $x_1 ... x_N$ and the stored interval sequences $y_1 ... y_N$ is determined using the relationship

$$d(x,y) = \sqrt[g]{\sum_{n=1}^{N} \left| x_n - y_n \right|^g}$$

where $1 \leq g < \infty$.

**8.** Apparatus for reception and for processing of a digitally frequency-modulated analogue received signal, comprising an apparatus for demodulation according to one or more of Claims 5 to 7.

## Revendications

**1.** Procédé de démodulation d'un signal de réception analogique, modulé en fréquence numériquement, dans un système de communication sans fil, dans lequel

- on détermine les intervalles de temps entre les passages par zéro du signal de réception ou d'un signal de fréquence intermédiaire produit à partir du signal de réception et on les utilise pour la détection des données de signal numériques ou de bits, dans lequel
- on détermine une multiplicité d'intervalles temporels entre des passages par zéro qui se succèdent, on compare la succession d'intervalles ainsi déterminée à un jeu de successions d'intervalles mémorisées, on détermine la succession d'intervalles mémorisée qui a la distance la plus petite à la succession d'intervalles déterminée et on détermine le nombre M de données de signal numériques associé à cette succession d'intervalles mémorisée, M étant égal ou supérieur à 2,

**caractérisé en ce que**

- on effectue de façon renouvelée successivement dans le temps, respectivement, à la distance d'une période de données de signal ou d'une période de bit, la comparaison de la succession d'intervalles déterminée au jeu de successions d'intervalles mémorisées, de manière à obtenir M résultats de détection pour chaque position de bit, et
- à partir des M résultats de détection, on détermine, par une décision de majorité, un résultat de détection final pour la position de bit respective.

**2.** Procédé suivant la revendication 1, **caractérisé en ce que**

- un compteur (2) compte des impulsions qui lui sont envoyées à une fréquence ($f_0$) prescrite,
- une impulsion de remise à l'état initial est envoyée au compteur (2) à chaque passage par zéro, et
- avant que le compteur (2) soit remis à l'état initial, l'état du compteur qui est obtenu est émis et est transformé en un signal représentant l'intervalle entre les passages par zéro précédents.

**3.** Procédé suivant la revendication 1 ou 2, **caractérisé en ce que**

- on détermine la distance entre la succession $x_1 \ldots x_N$ d'intervalles déterminée et les successions $y_1 \ldots y_N$ d'intervalles mémorisées par la relation

$$d(x, y) = \sqrt[g]{\sum_{n=1}^{N} |x_n - y_n|^g}$$

avec $1 \leq g < \infty$.

**4.** Procédé de réception et de traitement d'un signal de réception analogique, modulé en fréquence numériquement, comprenant un procédé de modulation suivant l'une ou plusieurs des revendications précédentes.

**5.** Dispositif de démodulation d'un signal de réception analogique, modulé en fréquence numériquement, dans un système de communication sans fil, comprenant

- un détecteur (1) de passage par zéro, et
- un dispositif (2) qui est relié au détecteur (1) de passage par zéro et qui est destiné à déterminer les intervalles temporels entre les passages par zéro, dans lequel
- le dispositif (2) de détermination des intervalles entre des passages par zéro est relié à un registre (3) à décalage pour mémoriser une succession d'intervalles de passage par zéro sous forme numérique, et
- le registre (3) à décalage est relié à un dispositif (4) de classification qui a
- un dispositif de mémorisation d'un jeu de successions d'intervalles et de données de signaux numériques respectivement associés et
- un dispositif de calcul de distance pour calculer la distance entre la succession d'intervalles déterminée et les successions d'intervalles mémorisées,

**caractérisé en ce que**

- le dispositif est conçu pour effectuer de façon renouvelée successivement dans le temps, respectivement, à la distance d'une période de données de signal du période de bit, la comparaison de la succession d'intervalles déterminée au jeu de successions d'intervalles mémorisées, de

manière à obtenir M résultats de détection pour chaque position de bit, et

- le dispositif (4) de classification est conçu pour déterminer à partir des M résultats de détection, par une décision de majorité, un résultat de détection final pour la position de bit respective.

**6.** Dispositif suivant la revendication 5, **caractérisé en ce que**

- le dispositif (2) de détection des intervalles entre les passages par zéro comprend un compteur (2) qui a une entrée d'impulsion d'horloge et une entrée d'impulsion de remise à l'état initial et une sortie, dans lequel
- un générateur d'impulsions d'horloge est relié à l'entrée d'impulsion d'horloge et le détecteur (1) de passage par zéro est relié à l'entrée d'impulsion de remise à l'état initial.

**7.** Dispositif suivant la revendication 5 ou 6, **caractérisé en ce que**

- le dispositif de calcul de distance détermine la distance entre la succession $x_1 \ldots x_N$ d'intervalles déterminée et les successions $y_1 \ldots y_N$ d'intervalles mémorisées suivant la relation

$$d(x, y) = \sqrt[g]{\sum_{n=1}^{N} |x_n - y_n|^g}$$

avec $1 \leq g < \infty$.

**8.** Dispositif de réception et de traitement d'un signal de réception analogique modulé en fréquence numériquement, comprenant un dispositif de démodulation suivant l'une ou plusieurs des revendications 5 à 7.

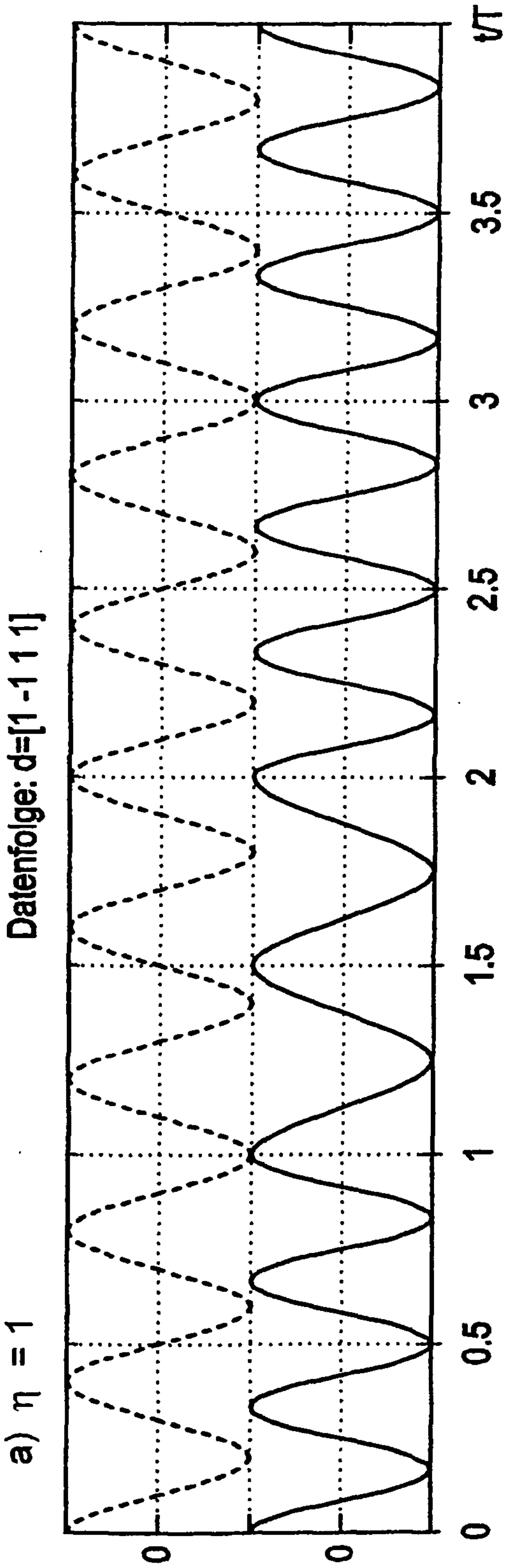


Fig. 1

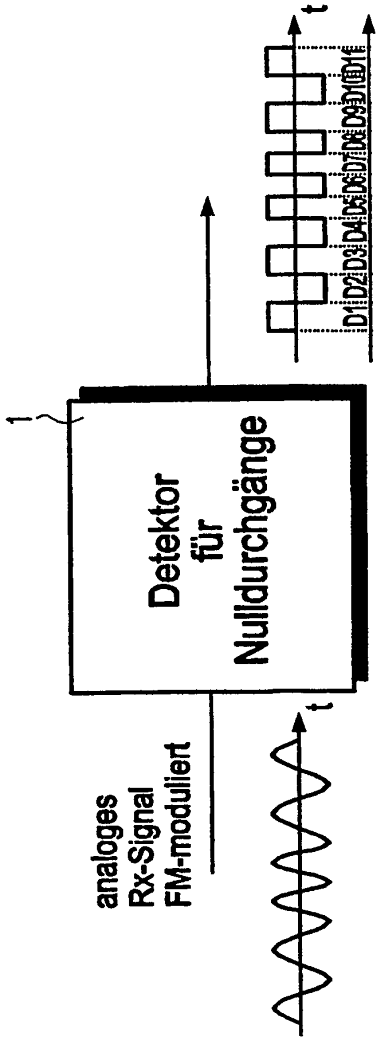
analoges
Rx-Signal
FM-moduliert
t
1
Detektor
für
Nulldurchgänge
t
D1 D2 D3 D4 D5 D6 D7 D8 D9 D10 D11

Fig.2A

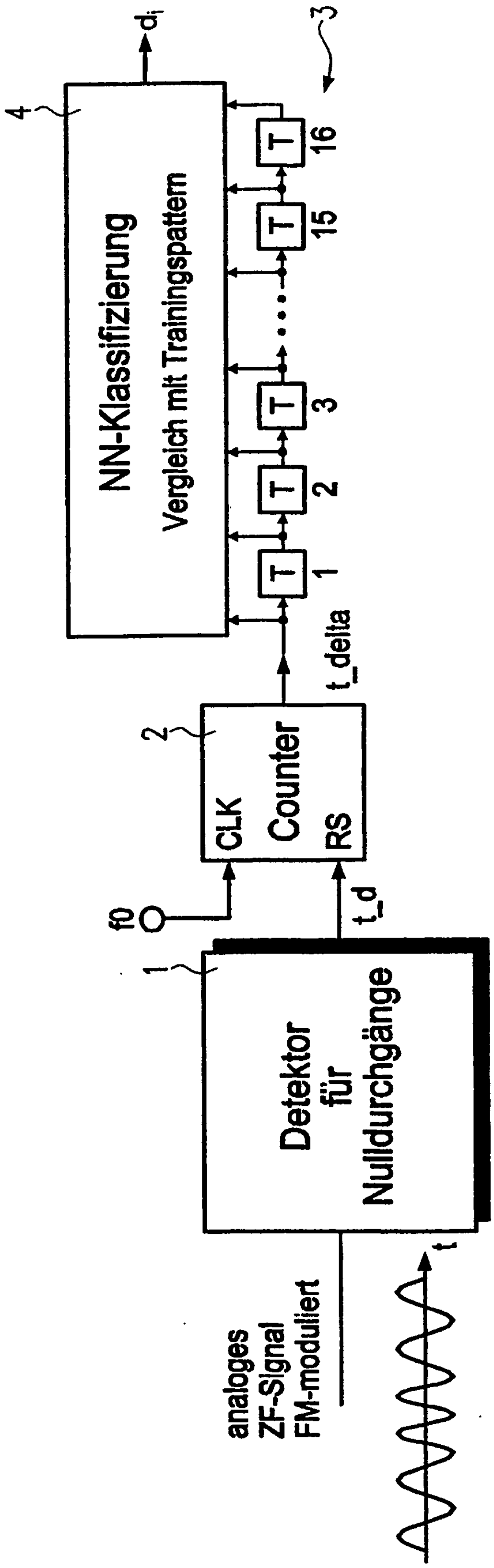
analoges
ZF-Signal
FM-moduliert
t
1
Detektor
für
Nulldurchgänge
t_d
f0
2
CLK
Counter
RS
t_delta
T
1
T
2
T
3
T
15
T
16
4
NN-Klassifizierung
Vergleich mit Trainingspattern
$d_i$
3

Fig.2B

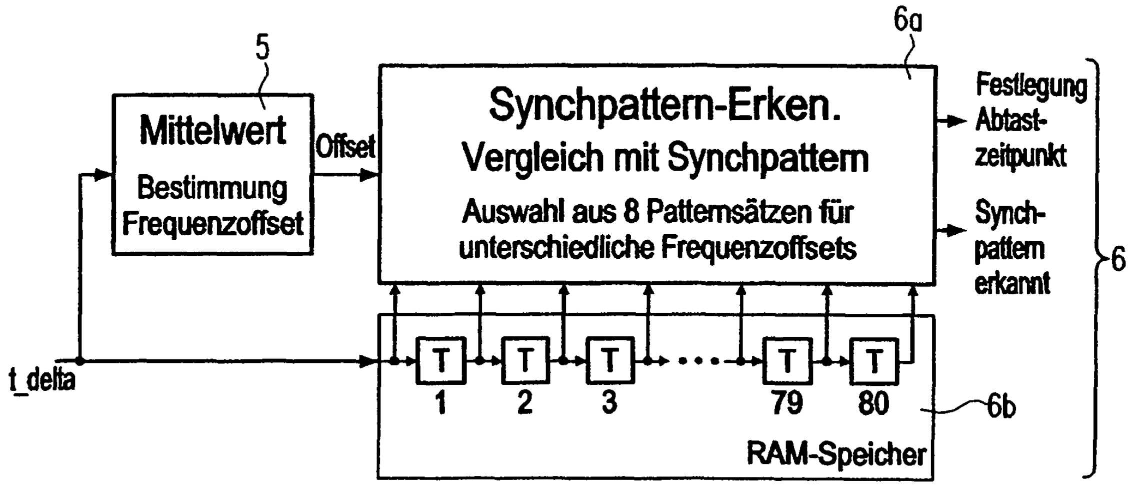

5
6a
Mittelwert
Bestimmung
Frequenzoffset
Offset
Synchpattern-Erken.
Vergleich mit Synchpattern
Auswahl aus 8 Patternsätzen für
unterschiedliche Frequenzoffsets
Festlegung
Abtast-
zeitpunkt
Synch-
pattern
erkannt
6
t_delta
T
1
2
3
79
80
6b
RAM-Speicher


Fig.3

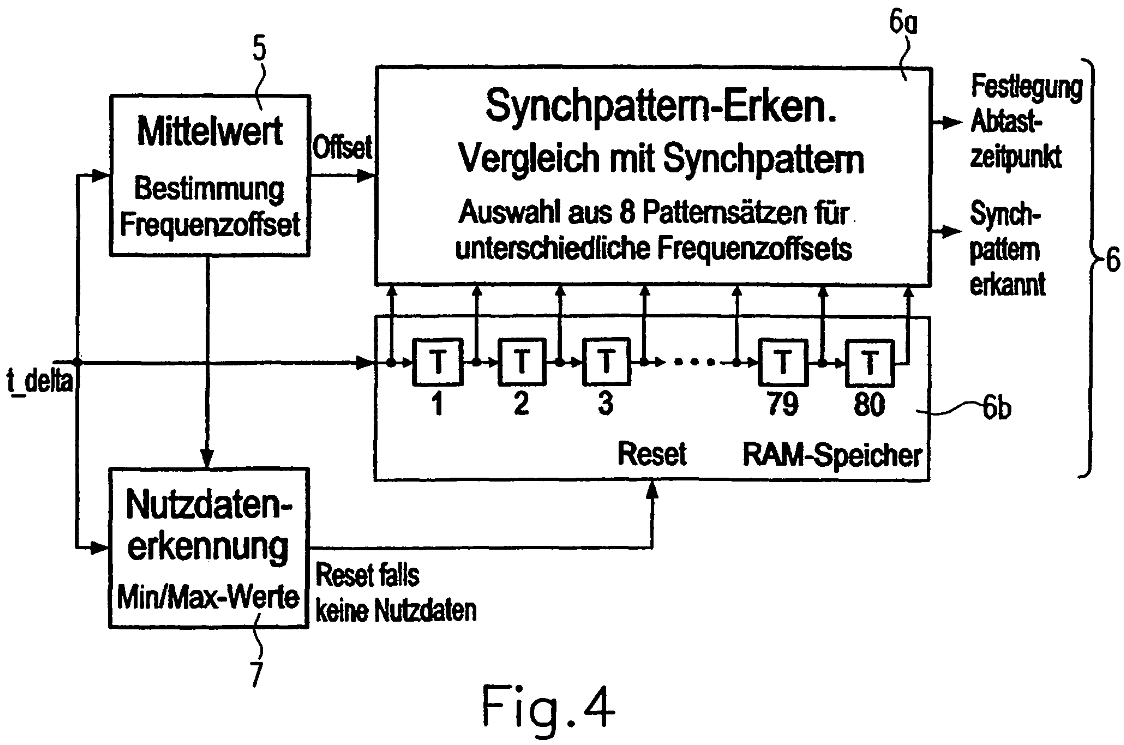

5
6a
Mittelwert
Bestimmung
Frequenzoffset
Offset
Synchpattern-Erken.
Vergleich mit Synchpattern
Auswahl aus 8 Patternsätzen für
unterschiedliche Frequenzoffsets
Festlegung
Abtast-
zeitpunkt
Synch-
pattern
erkannt
6
t_delta
T
1
2
3
79
80
6b
Reset
RAM-Speicher
Nutzdaten-
erkennung
Min/Max-Werte
Reset falls
keine Nutzdaten
7


Fig.4

## IN DER BESCHREIBUNG AUFGEFÜHRTE DOKUMENTE

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

### In der Beschreibung aufgeführte Patentdokumente


- DE 10103479
- EP 0529986 A2
- US 5103463 A


### In der Beschreibung aufgeführte Nicht-Patentliteratur


- **VON K. D. KAMMEYER ; B. G. TEUBNER.** Nachrichtenübertragung. Verlag, 1996